# EUROPEAN PATENT APPLICATION

(11) **EP 2 346 086 A1**
(43) Date of publication of application: **20.07.2011**
(21) Application number: 09824653.1
(22) Date of filing: 08.07.2009
(51) Int. Cl.: H01L 31/04

(54) **PHOTOELECTRIC CONVERSION DEVICE MANUFACTURING METHOD AND PHOTOELECTRIC CONVERSION DEVICE**

(30) Priority: 07.11.2008 JP 2008286442
(71) Applicant: Mitsubishi Heavy Industries, Ltd., Tokyo 108-8215 (JP)
(72) Inventor: GOYA, Saneyuki, Yokohama-shi Kanagawa 236-8515 (JP); SAKAI, Satoshi, Yokohama-shi Kanagawa 236-8515 (JP)
(74) Representative: Bongiovanni, Simone
(86) International application number: PCT/JP2009/062436
(87) International publication number: WO 2010/052953

(57) **Abstract**

A process for producing a photovoltaic device that suppresses variations in the photovoltaic conversion efficiency within the plane of a large surface area substrate, suppresses fluctuations in the module power output between production lots, and enables an improvement in the productivity. A process for producing a photovoltaic device (100) that includes forming a silicon-based photovoltaic layer (3) on a substrate (1) using a plasma enhanced CVD method that employs a gas containing a silane-based gas and hydrogen gas as the raw material gas, under conditions in which the flow rate of the hydrogen gas per unit surface area of the substrate (1) is not less than 80 slm/m².

## Description

### Technical Field

The present invention relates to a photovoltaic device, and relates particularly to a process for producing a thin-film silicon-based solar cell in which the electric power generation layer is formed by deposition, and a photovoltaic device prepared using this production process.

### Background Art

One known example of a photovoltaic device that converts the energy from sunlight into electrical energy is a thin-film silicon-based solar cell comprising a photovoltaic layer formed by using a plasma enhanced CVD method or the like to deposit thin films of a p-type silicon-based semiconductor (p-layer), an i-type silicon-based semiconductor (i-layer) and an n-type silicon-based semiconductor (n-layer). Advantages of thin-film silicon-based solar cells include the comparative ease with which the surface area can be increased, and the fact that the film thickness is approximately 1/100th that of a crystalline solar cell, meaning minimal material is required. As a result, thin-film silicon-based solar cells can be produced at lower cost than crystalline solar cells.

In order to improve the mass production potential for a thin-film silicon-based solar cell having a high conversion efficiency, increasing the deposition rate, and conducting the deposition so that the photovoltaic layer is formed with uniform quality within the substrate plane, thereby increasing the module power output are both important factors. For example, in the case of a solar cell that uses crystalline silicon, it is known that there is a relationship between the crystallinity of the crystalline silicon i-layer and the conversion efficiency of the solar cell.
Patent citation 1 and patent citation 2 disclose preferred deposition conditions for achieving rapid deposition of a high-quality photovoltaic layer.

However, in the production of a thin-film silicon layer using a plasma enhanced CVD method, the deposition conditions such as the raw material gas flow rate, the supplied electric power density, the substrate temperature and the substrate-electrode separation distance each tend to develop a distribution within the substrate plane. Further, fluctuations in the deposition conditions also occur between production lots. As a result, variations in the thin-film properties occur within the substrate plane and between production lots. Fluctuations in the deposition conditions within the substrate plane tend to be particularly problematic when a large surface area substrate with a substrate surface area of at least 1 m² is used. The existence within the substrate plane of regions having poor thin-film properties causes a deterioration in the solar cell module power output. Increased variation in the solar cell module power output between production lots is also a problem. For these reasons, it is necessary to evaluate the robustness of the thin-film properties under fluctuations in the deposition conditions, and to develop improvements in the production process.

Patent citation 3 discloses a process for depositing a transparent conductive film using an atmospheric pressure plasma enhanced CVD apparatus, wherein an evaluation is performed of the robustness of the resistivity value for the transparent electrode film upon variation in the type of reaction gas used.

Patent Citation 1: Japanese Unexamined Patent Application, Publication No. 2005-259853
Patent Citation 2: Japanese Unexamined Patent Application, Publication No. 2006-216921
Patent Citation 3: Japanese Unexamined Patent Application, Publication No. 2005-200737

### Disclosure of Invention

When photovoltaic layers are deposited within the ranges for deposition conditions disclosed in patent citation 1 and patent citation 2, even if the photovoltaic layers are deposited under identical conditions, a variation in the electric power output still occurs between modules. Although there have been numerous investigations of the deposition conditions which, like the patent citation 1 and the patent citation 2, are aimed at improving the solar cell performance, almost no evaluations have been conducted into the robustness of the cell performance under fluctuations in the deposition conditions.

The present invention has an object of providing a process for producing a photovoltaic device that suppresses variations in the photovoltaic conversion efficiency within the plane of a large surface area substrate, suppresses fluctuations in the solar cell module power output between production lots, and enables an improvement in the productivity. Furthermore, the present invention also has an object of providing a photovoltaic device that has a high power output as a result of using the above production process to control variations in the thin-film properties, and particularly the crystallinity, of the crystalline silicon i-layer within the substrate plane.

A process for producing a photovoltaic device according to the present invention comprises forming a silicon-based photovoltaic layer on a substrate using a plasma enhanced CVD method that employs a gas comprising a silane-based gas and hydrogen gas as the raw material gas, under conditions in which the flow rate of the hydrogen gas per unit surface area of the substrate is not less than 80 slm/m².

As a result of investigating the relationship between the deposition conditions for the silicon-based photovoltaic layer, the crystallinity of the silicon film and the performance of the photovoltaic device, the inventors of the present invention discovered that variations in the crystallinity and the photovoltaic conversion efficiency were clearly dependent on the flow rate of the deposition gas, and particularly the hydrogen gas flow rate per unit surface area of the substrate. They also discovered that if deposition was performed under the hydrogen gas flow rate conditions mentioned above, then the permissible fluctuation ranges for the total gas flow rate, the electric power density supplied to the plasma discharge electrode, the substrate temperature and the substrate-electrode separation distance for obtaining a certain level of conversion efficiency were all able to be broadened.
The gas flow rate and the substrate temperature readily develop a distribution within the substrate plane as the surface area of the substrate is increased. Furthermore, if the substrate develops warping, then the substrate-electrode separation distance tends to also vary within the substrate plane. When a photovoltaic device is produced using the production process of the present invention, because the process exhibits a high degree of robustness relative to fluctuations within the substrate plane of the total gas flow rate, the substrate temperature and the substrate-electrode separation distance, variations in the film quality and performance (photovoltaic conversion efficiency) can be suppressed even if a substrate in-plane distribution develops for one or more of the above deposition conditions. As a result, the electric power output per photovoltaic device can be improved.
Moreover, the gas flow rate and the effective supplied electric power is prone to fluctuations between production batches or lots. If the production process of the present invention is used, then because the process exhibits a high degree of robustness relative to fluctuations in the total gas flow rate and the supplied electric power, even if the gas flow rate and/or supplied electric power fluctuates between batches or between lots, the effect of such fluctuations on changes in the film quality and the photovoltaic conversion efficiency can be minimized. As a result, variations in the electric power output between production batches or lots can be suppressed.
In this manner, the production process of the present invention enables a high-quality product to be produced with good stability.

In the present invention, the robustness improvement effect is particularly large in the case of large surface area substrates having a substrate surface area of at least 1 m².
Large surface area substrates are prone to developing distributions within the substrate plane, including a gas distribution, substrate temperature distribution, and distributions in the electric power density supplied to the plasma discharge electrode and the substrate-electrode separation distance. In the production process of the present invention, variations in the film quality and photovoltaic conversion efficiency within the substrate plane can be suppressed even in those cases where a large surface area substrate is used, and therefore the electric power output per photovoltaic device can be increased. Furthermore, variations in the electric power output between production batches or lots can also be suppressed, meaning the productivity for high-quality large surface area photovoltaic devices can be improved.

In the present invention, the robustness improvement effect is larger when the photovoltaic layer is deposited at a high rate of at least 1.5 nm/s. The robustness improvement effect is particularly significant at deposition rates of 2 nm/s or higher.
Generally, when the photovoltaic layer is deposited at a high rate, the substrate in-plane distribution for the film thickness tends to increase. In those cases where the photovoltaic layer is composed of crystalline silicon, highspeed deposition tends to cause variation in the crystallinity. Further, in order to maintain productivity when deposition is conducted at a deposition rate lower than 1.5 nm/s, a plurality of deposition chambers must be positioned in parallel, so that multiple substrate deposition treatments can be conducted simultaneously, but this causes a dramatic increase in the plant equipment costs, and is therefore undesirable. In the process for producing a photovoltaic device according to the present invention, because variations in the film thickness and film quality can be suppressed even when the photovoltaic layer is deposited at a high deposition rate of 1.5 nm/s or higher, a high-power output photovoltaic device can be produced stably with a high level of productivity.

The present invention also provides a photovoltaic device produced using the production process described above, wherein the surface area of the substrate is not less than 1 m², the photovoltaic layer comprises a crystalline silicon i-layer, the crystalline silicon i-layer comprises a region for which the Raman peak ratio, which represents the ratio of the Raman peak intensity for the crystalline silicon phase relative to the Raman peak intensity for the amorphous silicon phase, is within a range from not less than 3.5 to not more than 8, and a surface area proportion of regions within the substrate plane for which the Raman peak ratio is not more than 2.5 is not more than 3%.

Improving the film quality of the crystalline silicon i-layer is particularly effective in improving the photovoltaic conversion efficiency of a photovoltaic device comprising a photovoltaic layer containing crystalline silicon. It was discovered that the highest electric power generation efficiency was achieved near the boundary between amorphism and crystallinity. Accordingly, in order to increase the power output of a large surface area thin-film silicon-based solar cell module, the occurrence of amorphous regions in the crystalline silicon i-layer within the substrate plane must be suppressed, but the occurrence of regions in which the crystallization ratio is overly high must also be suppressed. In other words, it is desirable to conduct deposition of the crystalline i-layer so that the degree of crystallinity within the substrate plane is of a uniform level within the vicinity of the boundary between amorphism and crystallinity.
A high-power output photovoltaic device can be obtained in those cases where the Raman peak ratio for the crystalline silicon i-layer is not less than 3.5 and not more than 8. However, in a large surface area substrate with a surface area exceeding 1 m², regions in which the Raman peak ratio is either very low or overly high are prone to developing locally due to the occurrence of distributions within the substrate plane, including a gas distribution, substrate temperature distribution, and distributions in the electric power density supplied to the plasma discharge electrode and the substrate-electrode separation distance. In particular, regions in which the Raman peak ratio is 2.5 or lower represent regions of high brightness (high-brightness reflective regions), which can cause a reduction in power output. Furthermore, in regions in which the Raman peak ratio is overly high, the open-circuit voltage decreases, causing a reduction in power output. Accordingly, in order to improve the power output from a photovoltaic device, it is necessary to ensure that the Raman peak ratio for the crystalline silicon i-layer is not less than 3.5 and not more than 8, and that the occurrence of high-brightness reflective regions is suppressed.
The production process of the present invention improves the robustness of the film quality (the crystallinity) under fluctuations within the substrate plane of the gas flow rate, the supplied electric power density, the substrate temperature and the substrate-electrode separation distance. Accordingly, the distribution of the film quality of the crystalline silicon i-layer within the substrate plane can be controlled, so that the regions for which the Raman peak ratio (namely, the crystallinity) for the crystalline silicon i-layer is within the range from not less than 3.5 to not more than 8 are in the majority, and the surface area proportion of regions within the substrate plane for which the Raman peak ratio is not more than 2.5 can be suppressed to not more than 3%. As a result, a photovoltaic device having a high module power output is obtained.
The Raman peak ratio in the present invention is measured using 532 nm light (the second harmonic of a YAG laser) as the measuring light source, and is represented by the ratio (the Raman peak ratio Ic/Ia) within the Raman spectrum of the peak intensity Ic for the crystalline silicon phase (the peak intensity close to a frequency of 520 cm⁻¹) relative to the peak intensity Ia for the amorphous silicon phase (the peak intensity close to a frequency of 480 cm⁻¹).

According to the present invention, variations in the film quality and the performance of the photovoltaic layer within the substrate plane can be suppressed, enabling the electric power output of the photovoltaic device to be increased. Moreover, variations in the electric power output between production batches or lots can also be minimized. As a result, the quality of the devices can be improved, and high-quality products can be produced stably with good yield, meaning the productivity can be raised significantly.
In particular, if the production process of the present invention is applied to deposition of a crystalline silicon i-layer, then the substrate in-plane crystallinity of the crystalline silicon i-layer can be adjusted so that those regions for which the Raman peak ratio is within a range from not less than 3.5 to not more than 8 are in the majority, while the surface area proportion of regions within the substrate plane for which the Raman peak ratio is not more than 2.5 can be suppressed to not more than 3%. As a result, a photovoltaic device having a high photovoltaic conversion efficiency is obtained.

### Brief Description of Drawings

[FIG. 1] A schematic representation illustrating the structure of a photovoltaic device produced using a process for producing a photovoltaic device according to the present invention.
[FIG. 2] A schematic illustration describing one embodiment for producing a solar cell panel using a process for producing a photovoltaic device according to the present invention.
[FIG. 3] A schematic illustration describing one embodiment for producing a solar cell panel using a process for producing a photovoltaic device according to the present invention.
[FIG. 4] A schematic illustration describing one embodiment for producing a solar cell panel using a process for producing a photovoltaic device according to the present invention.
[FIG. 5] A schematic illustration describing one embodiment for producing a solar cell panel using a process for producing a photovoltaic device according to the present invention.
[FIG. 6] A graph illustrating the relationship between the total gas flow rate during deposition of a crystalline silicon i-layer and the Raman peak ratio for the crystalline silicon i-layer.
[FIG. 7] A graph illustrating the relationship between the degree of fluctuation in the total gas flow rate during deposition of a crystalline silicon i-layer and the Raman peak ratio for the crystalline silicon i-layer.
[FIG. 8] A graph illustrating the relationship between the total gas flow rate during deposition of a crystalline silicon i-layer and the module power output for a tandem solar cell.
[FIG. 9] A graph illustrating the relationship between the degree of fluctuation in the total gas flow rate during deposition of a crystalline silicon i-layer and the module power output for a tandem solar cell.
[FIG. 10] A graph illustrating the relationship between the substrate-electrode separation distance during deposition of a crystalline silicon i-layer and the Raman peak ratio for the crystalline silicon i-layer.
[FIG. 11] A graph illustrating the relationship between the substrate-electrode separation distance during deposition of a crystalline silicon i-layer and the module power output for a tandem solar cell.
[FIG. 12] A graph illustrating the relationship between the electric power density during deposition of a crystalline silicon i-layer and the Raman peak ratio for the crystalline silicon i-layer.
[FIG. 13] A graph illustrating the relationship between the electric power density during deposition of a crystalline silicon i-layer and the module power output for a tandem solar cell.
[FIG. 14] A graph illustrating the relationship between the glass substrate temperature during deposition of a crystalline silicon i-layer and the Raman peak ratio for the crystalline silicon i-layer.
[FIG. 15] A graph illustrating the relationship between the substrate temperature during deposition of a crystalline silicon i-layer and the module power output for a tandem solar cell.

### Explanation of Reference:

- 1:: Substrate
- 2:: Transparent electrode layer
- 3:: Photovoltaic layer
- 4:: Back electrode layer
- 5:: Intermediate contact layer
- 6:: Solar cell module
- 31:: Amorphous silicon p-layer
- 32:: Amorphous silicon i-layer
- 33:: Amorphous silicon n-layer
- 41:: Crystalline silicon p-layer
- 42:: Crystalline silicon i-layer
- 43:: Crystalline silicon n-layer
- 91:: First cell layer
- 92:: Second cell layer
- 100:: Photovoltaic device

### Best Mode for Carrying Out the Invention

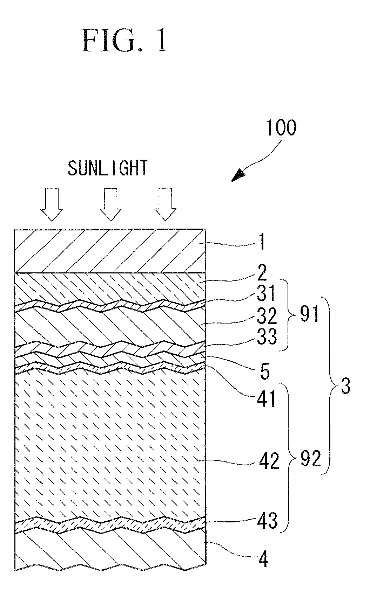

FIG. 1 is a schematic representation illustrating the structure of a photovoltaic device according to the present invention. A photovoltaic device 100 is a tandem silicon-based solar cell, and comprises a substrate 1, a transparent electrode layer 2, a first cell layer 91 (amorphous silicon-based) and a second cell layer 92 (crystalline silicon-based) as a photovoltaic layer 3, an intermediate contact layer 5, and a back electrode layer 4. Here, the term "silicon-based" is a generic term that includes silicon (Si), silicon carbide (SiC) and silicon germanium (SiGe). Further, the term "crystalline silicon-based" describes a silicon system other than an amorphous silicon system, and includes both microcrystalline silicon systems and polycrystalline silicon systems.

An embodiment in which the production process according to the present invention is applied to the deposition of a crystalline silicon i-layer is described below, using the production steps for a solar cell panel as an example.

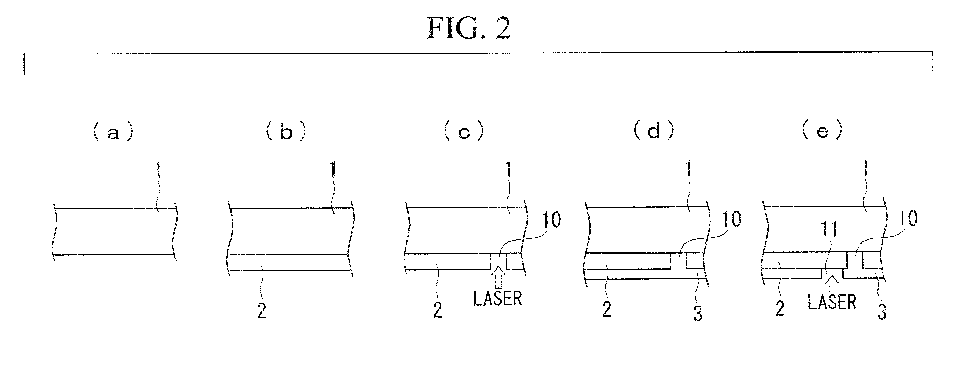

FIG. 2 to FIG. 5 are schematic representations illustrating the process for producing a solar cell panel according to this embodiment.

### (1) FIG. 2(a)

A soda float glass substrate with a surface area of at least 1 m² (for example with dimensions of 1.4 m × 1.1 m × thickness: 3.5 to 4.5 mm) is used as the substrate 1. The edges of the substrate are preferably subjected to corner chamfering or R-face chamfering to prevent damage caused by thermal stress or impacts or the like.

### (2) FIG. 2(b)

A transparent electrode film comprising mainly tin oxide (SnO₂) and having a film thickness of approximately not less than 500 nm and not more than 800 nm is deposited as the transparent electrode layer 2, using a thermal CVD apparatus at a temperature of approximately 500°C. During this deposition, a texture comprising suitable asperity is formed on the surface of the transparent electrode film. In addition to the transparent electrode film, the transparent electrode layer 2 may also include an alkali barrier film (not shown in the figure) formed between the substrate 1 and the transparent electrode film. The alkali barrier film is formed using a thermal CVD apparatus at a temperature of approximately 500°C to deposit a silicon oxide film (SiO₂) having a film thickness of 50 nm to 150 nm.

### (3) FIG. 2(c)

Subsequently, the substrate 1 is mounted on an X-Y table, and the first harmonic of a YAG laser (1064 nm) is irradiated onto the surface of the transparent electrode film, as shown by the arrow in the figure. The laser power is adjusted to ensure an appropriate process speed, and the transparent electrode film is then moved in a direction perpendicular to the direction of the series connection of the electric power generation cells, thereby causing a relative movement between the substrate 1 and the laser light, and conducting laser etching across a strip having a predetermined width of approximately 6 mm to 15 mm to form a slot 10.

### (4) FIG. 2(d)

Using a plasma enhanced CVD apparatus, a p-layer, an i-layer and an n-layer, each composed of a thin film of amorphous silicon, are deposited as the first cell layer 91. Using silane (SiH₄) gas and hydrogen (H₂) gas as the main raw materials, and under conditions including a reduced pressure atmosphere of not less than 30 Pa and not more than 1,000 Pa and a substrate temperature of approximately 200°C, an amorphous silicon p-layer 31, an amorphous silicon i-layer 32 and an amorphous silicon n-layer 33 are deposited, in that order, on the transparent electrode layer 2, with the p-layer closest to the surface from which incident sunlight enters. The amorphous silicon p-layer 31 comprises mainly amorphous B-doped silicon, and has a film thickness of not less than 10 nm and not more than 30 nm. The amorphous silicon i-layer 32 has a film thickness of not less than 200 nm and not more than 350 nm. The amorphous silicon n-layer 33 comprises mainly P-doped silicon in which microcrystalline silicon is incorporated within amorphous silicon, and has a film thickness of not less than 30 nm and not more than 50 nm. A buffer layer may be provided between the amorphous silicon p-layer 31 and the amorphous silicon i-layer 32 in order to improve the interface properties.

Next, using a plasma enhanced CVD apparatus, using silane gas and hydrogen gas as the main raw materials, and under conditions including a reduced pressure atmosphere of not more than 3,000 Pa, a substrate temperature of approximately 200°C and a plasma generation frequency of not less than 40 MHz and not more than 100 MHz, a crystalline silicon p-layer 41, a crystalline silicon i-layer 42 and a crystalline silicon n-layer 43 are deposited, in that order, as the second cell layer 92 on top of the first cell layer 91. The crystalline silicon p-layer 41 comprises mainly B-doped microcrystalline silicon, and has a film thickness of not less than 10 nm and not more than 50 nm. The crystalline silicon i-layer 42 comprises mainly microcrystalline silicon, and has a film thickness of not less than 1.2 µm and not more than 3.0 µm. The crystalline silicon n-layer 43 comprises mainly P-doped microcrystalline silicon, and has a film thickness of not less than 20 nm and not more than 50 nm.

During formation of the i-layer film comprising mainly microcrystalline silicon using a plasma enhanced CVD method, a distance d between the plasma discharge electrode and the surface of the substrate 1 is preferably not less than 3 mm and not more than 10 mm. If this distance d is less than 3 mm, then the precision of the various structural components within the film deposition chamber required for processing large substrates means that maintaining the distance d at a constant value becomes difficult, which increases the possibility of the electrode getting too close and making the discharge unstable. If the distance d exceeds 10 mm, then achieving a satisfactory deposition rate (of at least 1 nm/s) becomes difficult, and the uniformity of the plasma also deteriorates, causing a deterioration in the quality of the film due to ion impact.

During the deposition of the crystalline silicon i-layer 42, the hydrogen gas flow rate per unit surface area of the substrate, in a standard state at 0°C and 101.3 kPa, is typically not less than 80 slm/m² (135 Pa·m³/s/m²), is preferably not less than 100 slm/m² (169 Pa·m³/s/m²), and is more preferably not less than 156 slm/m² (264 Pa·m³/s/m²). Silane gas or disilane gas or the like is typically used as the silane-based gas, and using silane gas as a representative example, the silane gas flow rate is set appropriately so as to achieve a hydrogen dilution ratio that yields a crystalline silicon i-layer of a predetermined film quality (crystallinity). In the present embodiment, the hydrogen dilution ratio, which represents the ratio of the hydrogen gas flow rate relative to the silane-based gas flow rate (hydrogen gas flow rate / silane-based gas flow rate) is set to a value of not less than 40 and not more than 150. At a hydrogen dilution ratio of less than 40, achieving crystallinity with a Raman peak ratio of at least 3.5 becomes difficult. If the hydrogen dilution ratio exceeds 150, then regions having an overly high Raman peak ratio are formed and the open-circuit voltage decreases, causing a reduction in the power output.
As the hydrogen gas flow rate and the silane gas flow rate are increased, the production costs also tend to increase. Provided the hydrogen gas flow rate per unit surface area of the substrate is not more than 260 slm/m² (440 Pa·m³/s/m²), a favorable improvement in the electric power output for the solar cell can be achieved without any dramatic increase in the production costs.

An intermediate contact layer 5 that functions as a semi-reflective film for improving the contact properties and achieving electrical current consistency may be provided between the first cell layer 91 and the second cell layer 92. For example, a GZO (Ga-doped ZnO) film with a film thickness of not less than 20 nm and not more than 100 nm may be deposited as the intermediate contact layer 5 using a sputtering apparatus with a Ga-doped ZnO sintered body as the target. Further, in some cases the contact layer 5 need not be provided.

### (5) FIG. 2(e)

The substrate 1 is mounted on an X-Y table, and the second harmonic of a laser diode excited YAG laser (532 nm) is irradiated onto the film surface of the photovoltaic layer 3, as shown by the arrow in the figure. With the pulse oscillation set to 10 kHz to 20 kHz, the laser power is adjusted so as to achieve a suitable process speed, and laser etching is conducted at a point approximately 100 µm to 150 µm to the side of the laser etching line within the transparent electrode layer 2, so as to form a slot 11. The laser may also be irradiated from the side of the substrate 1, and in this case, because the high vapor pressure generated by the energy absorbed by the amorphous silicon-based first cell layer of the photovoltaic layer 3 can be utilized in etching the photovoltaic layer 3, more stable laser etching processing can be performed. The position of the laser etching line is determined with due consideration of positioning tolerances, so as not to overlap with the previously formed etching line.

### (6) FIG. 3(a)

Using a sputtering apparatus, an Ag film and a Ti film are deposited sequentially as the back electrode layer 4 under a reduced pressure atmosphere and at a deposition temperature of approximately 150°C to 200°C. In this embodiment, an Ag film having a thickness of not less than 150 nm and not more than 500 nm, and a highly corrosion-resistant Ti film having a thickness of not less than 10 nm and not more than 20 nm which acts as a protective film for the Ag film are stacked in that order. Alternatively, the back electrode layer 4 may be formed as a stacked structure composed of a Ag film having a thickness of 25 nm to 100 nm, and an Al film having a thickness of 15 nm to 500 nm. In order to reduce the contact resistance between the crystalline silicon n-layer 43 and the back electrode layer 4 and improve the reflectance, a GZO (Ga-doped ZnO) film with a film thickness of not less than 50 nm and not more than 100 nm may be deposited between the photovoltaic layer 3 and the back electrode layer 4 using a sputtering apparatus.

### (7) FIG. 3(b)

The substrate 1 is mounted on an X-Y table, and the second harmonic of a laser diode excited YAG laser (532 nm) is irradiated through the substrate 1, as shown by the arrow in the figure. The laser light is absorbed by the photovoltaic layer 3, and by utilizing the high gas vapor pressure generated at this point, the back electrode layer 4 is removed by explosive fracture. With the pulse oscillation set to not less than 1 kHz and not more than 10 kHz, the laser power is adjusted so as to achieve a suitable process speed, and laser etching is conducted at a point approximately 250 µm to 400 µm to the side of the laser etching line within the transparent electrode layer 2, so as to form a slot 12.

### (8) FIG. 3(c) and FIG. 4(a)

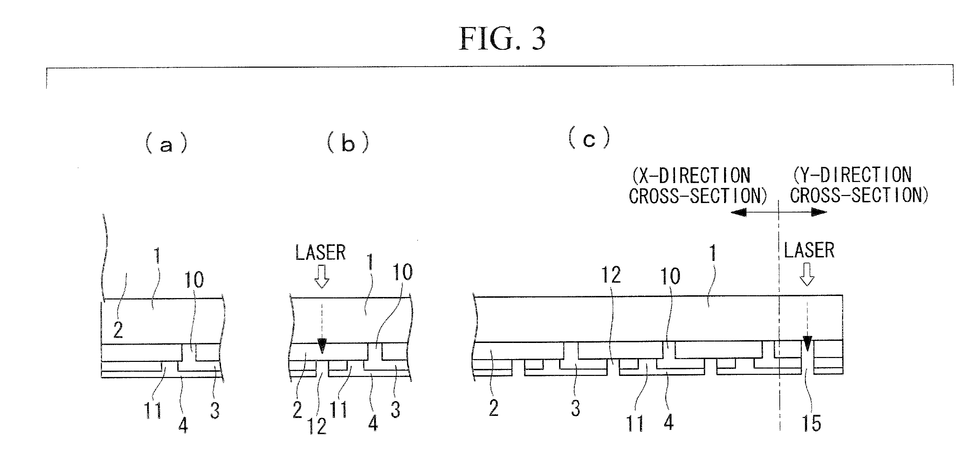

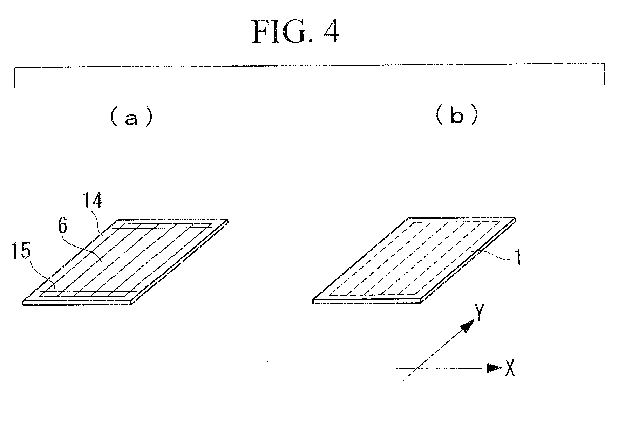

The electric power generation region is then compartmentalized, by using laser etching to remove the effect wherein the serially connected portions at the film edges near the edges of the substrate are prone to short circuits. The substrate 1 is mounted on an X-Y table, and the second harmonic of a laser diode excited YAG laser (532 nm) is irradiated through the substrate 1. The laser light is absorbed by the transparent electrode layer 2 and the photovoltaic layer 3, and by utilizing the high gas vapor pressure generated at this point, the back electrode layer 4 is removed by explosive fracture, and the back electrode layer 4, the photovoltaic layer 3 and the transparent electrode layer 2 are removed. With the pulse oscillation set to not less than 1 kHz and not more than 10 kHz, the laser power is adjusted so as to achieve a suitable process speed, and laser etching is conducted at a point approximately 5 mm to 20 mm from the edge of the substrate 1, so as to form an X-direction insulation slot 15 as illustrated in FIG. 3(c). FIG. 3(c) represents an X-direction cross-sectional view cut along the direction of the series connection of the photovoltaic layer 3, and therefore the location in the figure where the insulation slot 15 is formed should actually appear as a peripheral film removed region 14 in which the back electrode layer 4, the photovoltaic layer 3 and the transparent electrode layer 2 have been removed by film polishing (see FIG. 4(a)), but in order to facilitate description of the processing of the edges of the substrate 1, this location in the figure represents a Y-direction cross-sectional view, so that the formed insulation slot represents an X-direction insulation slot 15. A Y-direction insulation slot need not be provided at this point, because a film surface polishing and removal treatment is conducted on the peripheral film removal regions of the substrate 1 in a later step.

Completing the etching of the insulation slot 15 at a position 5 mm to 15 mm from the edge of the substrate 1 is preferred, as it ensures that the insulation slot 15 is effective in inhibiting external moisture from entering the interior of the solar cell module 6 via the edges of the solar cell panel.

Although the laser light used in the steps until this point has been specified as YAG laser light, light from a YV04 laser or fiber laser or the like may also be used in a similar manner.

### (9) FIG. 4 (a: view from solar cell film surface side, b: view from substrate side of light incident surface)

In order to ensure favorable adhesion and sealing of a backing sheet 24 via EVA or the like in a subsequent step, the stacked films around the periphery of the substrate 1 (in a peripheral film removal region 14), which tend to be uneven and prone to peeling, are removed to form a peripheral film removed region 14. During removal of the films from a region that is 5 mm to 20 mm from the edge around the entire periphery of the substrate 1, grinding or blast polishing or the like is used to remove the back electrode layer 4, the photovoltaic layer 3 and the transparent electrode layer 2 from a region that is closer to the substrate edge in the X direction than the insulation slot 15 provided in the above step of FIG. 3(c), and closer to the substrate edge in the Y direction than the slot 10 provided near the substrate edge.
Grinding debris or abrasive grains are removed by washing the substrate 1.

### (10) FIG. 5(a) (b)

An attachment portion for a terminal box 23 is prepared by providing an open through-window in the backing sheet 24 to expose a collecting plate. A plurality of layers of an insulating material are provided in this open through-window portion in order to prevent external moisture and the like entering the solar cell module.
Processing is conducted so as to enable current collection, using a copper foil, from the series-connected solar cell electric power generation cell at one end, and the solar cell electric power generation cell at the other end, in order to enable electric power to be extracted from the terminal box 23 on the rear surface of the solar cell panel. In order to prevent short circuits between the copper foil and the various portions, an insulating sheet that is wider than the width of the copper foil is provided.
Following arrangement of the collecting copper foil and the like at predetermined positions, the entire solar cell module 6 is covered with a sheet of an adhesive filling material such as EVA (ethylene-vinyl acetate copolymer), which is arranged so as not to protrude beyond the substrate 1.
A backing sheet 24 with a superior waterproofing effect is then positioned on top of the EVA. In this embodiment, in order to achieve a superior waterproofing and moisture-proofing effect, the backing sheet 24 is formed as a three-layer structure comprising a PET sheet, an Al foil and a PET sheet.
The structure comprising the components up to and including the backing sheet 24 arranged in predetermined positions is subjected to internal degassing under a reduced pressure atmosphere and under pressing at approximately 150°C to 160°C using a laminator, thereby causing cross-linking of the EVA that tightly seals the structure.

### (11) FIG. 5(a)

The terminal box 23 is attached to the back of the solar cell module 6 using an adhesive.

### (12) FIG. 5(b)

The copper foil and an output cable from the terminal box 23 are connected using solder or the like, and the interior of the terminal box 23 is filled and sealed with a sealant (a potting material). This completes the production of the solar cell panel 50.

### (13) FIG. 5(c)

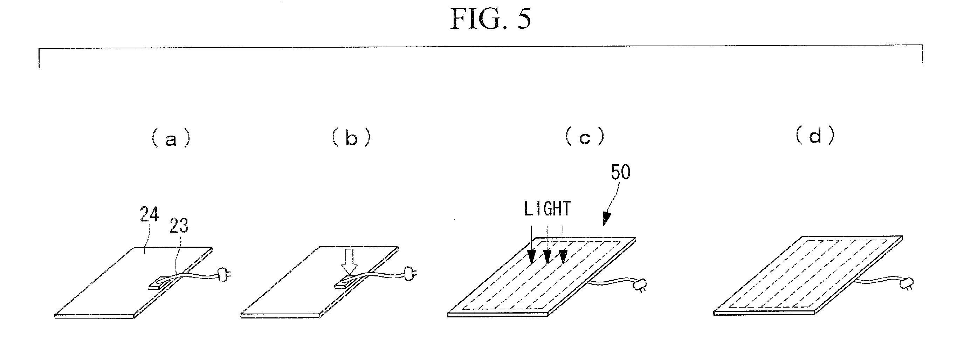

The solar cell panel 50 formed via the steps up to and including FIG. 5(b) is then subjected to an electric power generation test, as well as other tests for evaluating specific performance factors. The electric power generation test is conducted using a solar simulator that emits a standard sunlight of AM 1.5 (1,000 W/m²).

### (14) FIG. 5(d)

In tandem with the electric power generation test (FIG. 5(c)), a variety of specific performance factors including the external appearance are evaluated.

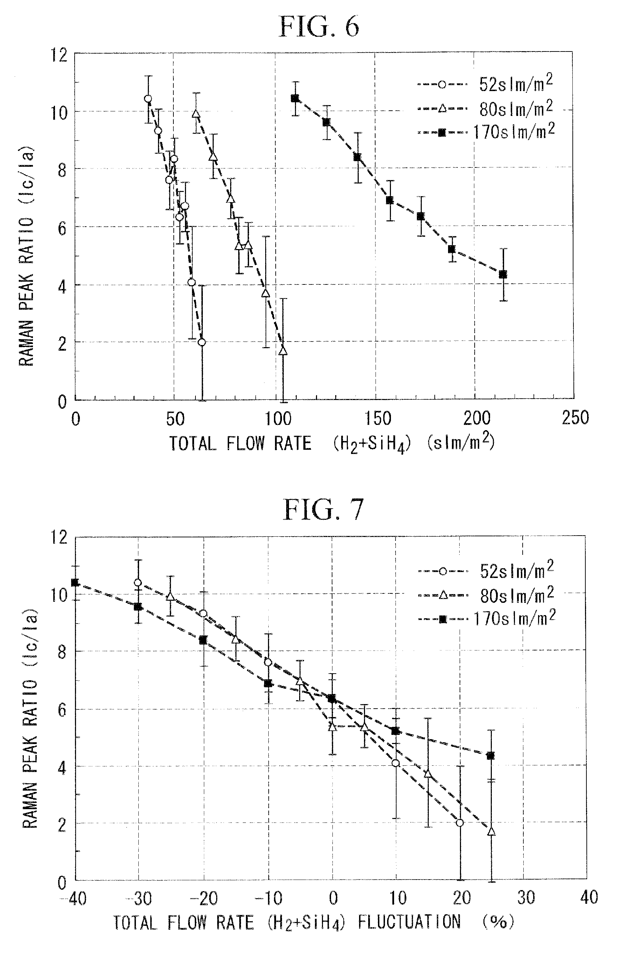

FIG. 6 illustrates the relationship between the total gas flow rate (hydrogen gas flow rate + silane gas flow rate) and the Raman peak ratio for the crystalline silicon i-layer when the crystalline silicon i-layer is deposited on a glass substrate under different values for the hydrogen gas flow rate per unit surface area of the substrate. In this figure, the horizontal axis represents the total gas flow rate, and the vertical axis represents the Raman peak ratio. FIG. 7 illustrates the change in the Raman peak ratio for the crystalline silicon i-layer upon fluctuation in the total gas flow rate. In this figure, the horizontal axis represents the degree of fluctuation in the total gas flow rate, and the vertical axis represents the Raman peak ratio. The degree of fluctuation in the total gas flow rate represents the amount of variation from the standard total gas flow rate set under each set of conditions. In FIG. 6 and FIG. 7, average values are represented by the symbol marks, and the distribution within the substrate plane is represented by an error bar in each case. A conventional hydrogen gas flow rate of 52 slm/m² was deemed to be 1 (the standard), and hydrogen gas flow rates of 80 slm/m², which represents a 1.5-fold increase, and 170 slm/m², which represents a 3-fold increase, were selected.

The size of the glass substrate was 1.4 m × 1.1 m. The deposition conditions besides the total gas flow rate (such as the substrate-electrode separation distance, the electric power density supplied to the plasma discharge electrode, and the substrate temperature) were fixed.
Under the conventional conditions represented by a hydrogen gas flow rate of 52 slm/m², the standard conditions (namely, the conditions when the degree of fluctuation in the total gas flow rate shown in FIG. 7 was 0) included a hydrogen dilution ratio of 40-fold to 150-fold, a substrate temperature of 190°C, an electric power density supplied to the plasma discharge electrode within a range from 1.5 W/m² to 2.0 W/m², and a deposition rate of 2 nm/s.

As illustrated in FIG. 6, when the hydrogen gas flow rate was 52 slm/m², the Raman peak ratio decreased rapidly as the total gas flow rate increased. As the hydrogen gas flow rate per unit surface area of the substrate was increased, the variation in the Raman peak ratio upon increases in the total gas flow rate tended to become more gentle. Further, as illustrated in FIG. 7, as the hydrogen gas flow rate per unit surface area of the substrate was increased, the variation in the Raman peak ratio upon fluctuations in the total gas flow rate tended to decrease. The results of FIG. 6 and FIG. 7 confirm that a larger hydrogen gas flow rate per unit surface area of the substrate improves the robustness of the film quality relative to fluctuations in the total gas flow rate. Accordingly, by setting the hydrogen gas flow rate to a value of not less than 80 slm/m², the range of total gas flow rate conditions that yield a Raman peak ratio within the target numerical range can be broadened, meaning the distribution of Raman peak ratio values within the plane of a large surface area substrate can be kept within the target numerical range, and a film quality distribution that is stable with respect to fluctuations in the deposition conditions can be achieved.

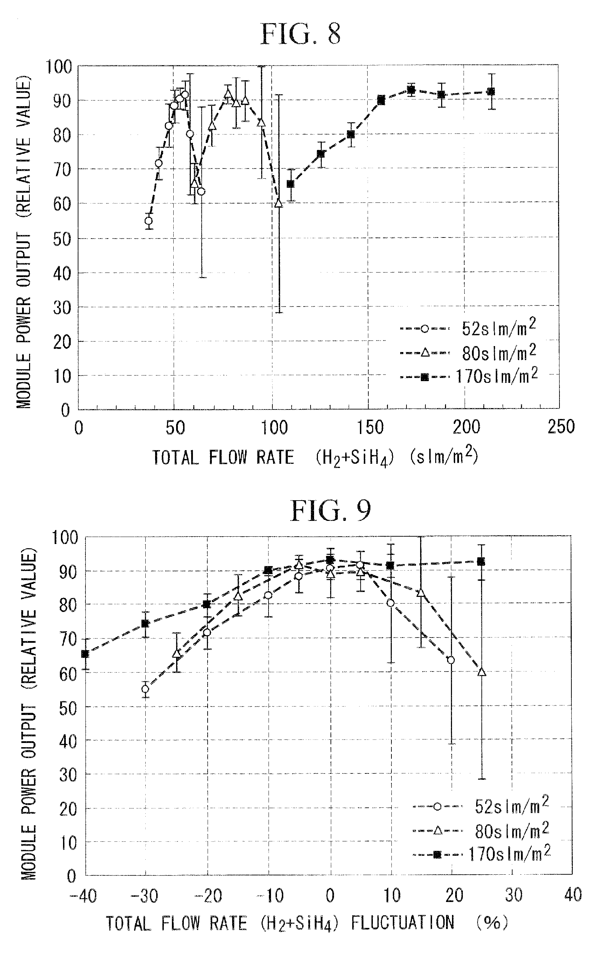

FIG. 8 illustrates the relationship between the total gas flow rate during deposition of the crystalline silicon i-layer and the module power output (stabilized power output) for a tandem solar cell comprising amorphous silicon and crystalline silicon. In this figure, the horizontal axis represents the total gas flow rate, and the vertical axis represents the module power output. FIG. 9 illustrates the variation in the tandem solar cell module power output (stabilized power output) upon fluctuation in the total gas flow rate during deposition of the crystalline silicon i-layer. In this figure, the horizontal axis represents the degree of fluctuation in the total gas flow rate, and the vertical axis represents a relative value for the module power output (stabilized power output). Under the conventional conditions represented by a hydrogen gas flow rate of 52 slm/m², the standard conditions (namely, the conditions when the degree of fluctuation in the total gas flow rate shown in FIG. 9 was 0) included a hydrogen dilution ratio of 40-fold to 150-fold, a substrate temperature of 190°C, an electric power density supplied to the plasma discharge electrode within a range from 1.5 W/m² to 2.0 W/m², and a deposition rate of 2 nm/s.

As is evident in FIG, 8 and FIG. 9, regardless of the value for the hydrogen gas flow rate per unit surface area of the substrate, the maximum module power output was substantially constant, although as the hydrogen gas flow rate per unit surface area of the substrate was increased, the width of the curve yielding a module power output value close to the maximum power output broadened. This result indicates that increasing the hydrogen gas flow rate per unit surface area of the substrate improves the robustness of the solar cell module power output relative to fluctuations in the total gas flow rate.

As mentioned above, provided the hydrogen gas flow rate per unit surface area of the substrate is at least 80 slm/m² (at least 1.5 times the conventional hydrogen gas flow rate), the effect of the hydrogen gas flow rate on the crystallinity of the silicon i-layer can be minimized. Further, the permissible degree of fluctuation in the total gas flow rate that enables the effect of the silicon i-layer on the cell performance to be reduced to not more than approximately 10% is equivalent to a fluctuation of ±15% or more, which represents a greater than 2-fold increase in the permissible fluctuation range compared with the conventional conditions. As a result, even if regions with different gas flow rates occur within the substrate plane during deposition of the crystalline silicon i-layer, the generation of regions having a low photovoltaic conversion efficiency can be inhibited, and therefore the overall electric power output of the solar cell can be increased. Furthermore, even if the gas flow rate fluctuates between production batches or lots, because any variation in the cell performance is minimal, the distribution in power output values across the different batches or lots can be narrowed significantly.

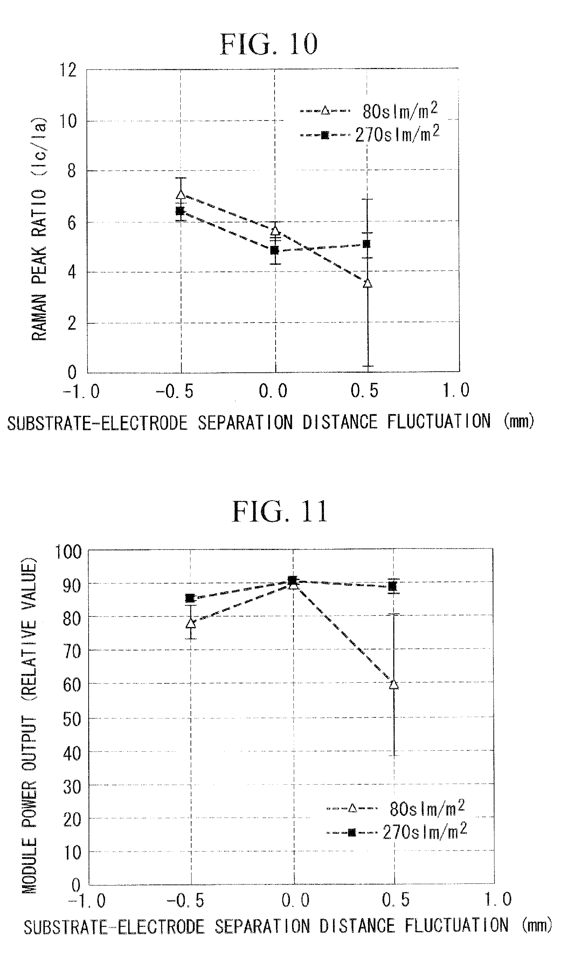

FIG. 10 illustrates the relationship between the substrate-electrode separation distance and the Raman peak ratio for the crystalline silicon i-layer. In this figure, the horizontal axis represents the substrate-electrode separation distance, and the vertical axis represents the Raman peak ratio. The size of the glass substrate was 1.4 m × 1.1 m. The deposition rate was not less than 2 nm/s under the standard central conditions. The deposition conditions besides the substrate-electrode separation distance (such as the total gas flow rate, the supplied electric power density, and the substrate temperature) were fixed. A conventional hydrogen gas flow rate of 52 slm/m² was deemed to be 1 (the standard), and the hydrogen gas flow rate was set to 270 slm/m², which represents a 5-fold increase.
As the hydrogen gas flow rate per unit surface area of the substrate was increased, reductions in the Raman peak ratio were able to be suppressed, particularly under those conditions where the substrate-electrode separation distance was large, which tends to promote a shift to amorphism. In other words, increasing the hydrogen gas flow rate per unit surface area of the substrate improved the robustness of the film quality relative to fluctuations in the substrate-electrode separation distance.

FIG. 11 illustrates the relationship between the substrate-electrode separation distance during deposition of the crystalline silicon i-layer and the module power output (stabilized power output) for a tandem solar cell comprising amorphous silicon and crystalline silicon. In this figure, the horizontal axis represents the substrate-electrode separation distance, and the vertical axis represents a relative value for the module power output (stabilized power output). Regardless of the value for the hydrogen gas flow rate per unit surface area of the substrate, the maximum module power output (stabilized power output) was substantially constant. Even under conditions where the substrate-electrode separation distance was wider than the standard conditions (which facilitates a shift to amorphism), or conditions where the substrate-electrode separation distance was narrower than the standard conditions (which facilitates crystallization), by increasing the hydrogen gas flow rate per unit surface area of the substrate, any reductions in the module power output were able to be suppressed. In this manner, increasing the hydrogen gas flow rate per unit surface area of the substrate improved the robustness of the module power output relative to fluctuations in the substrate-electrode separation distance.

As mentioned above, provided the hydrogen gas flow rate per unit surface area of the substrate is at least 80 slm/m², the effect of the hydrogen gas flow rate on the crystallinity of the silicon i-layer can be minimized. Further, the permissible degree of fluctuation in the substrate-electrode separation distance that enables the effect of the silicon i-layer on the cell performance to be reduced to not more than approximately 10% is equivalent to a fluctuation of not more than ±0.5 mm. In other words, adjustments within a typical mechanical adjustment range are permitted. As a result, the electric power output of the solar cell can be increased.

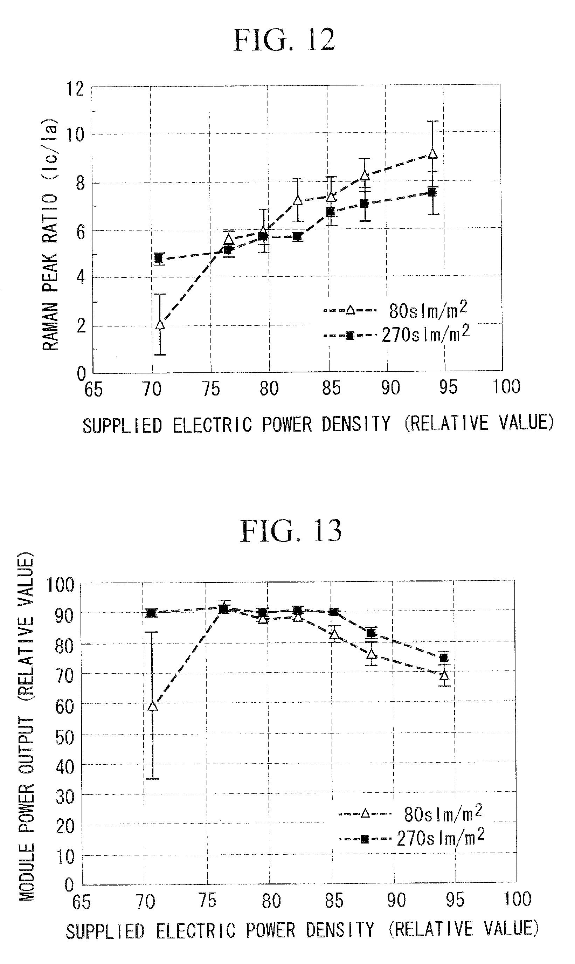

FIG. 12 illustrates the relationship between the electric power density supplied to the plasma discharge electrode and the Raman peak ratio for the crystalline silicon i-layer. In this figure, the horizontal axis represents the supplied electric power density, and the vertical axis represents the Raman peak ratio. The supplied electric power density is shown as a relative value in which the conditions that yield a deposition rate of 2 nm/s were deemed to be 82.5. The size of the glass substrate was 1.4 m × 1.1 m. The deposition rate was not less than 2 nm/s under the standard central conditions. The deposition conditions besides the supplied electric power density (such as the total gas flow rate, the substrate-electrode separation distance, and the substrate temperature) were fixed.
The Raman peak ratio and the crystallinity tended to increase as the supplied electric power density was increased, whereas the Raman peak ratio tended to decrease, facilitating a shift to amorphism, as the supplied electric power density decreased. As shown in the results, increasing the hydrogen gas flow rate per unit surface area of the substrate improved the robustness of the film quality relative to fluctuations in the supplied electric power density.

FIG. 13 illustrates the relationship between the electric power density during deposition of the crystalline silicon i-layer and the module power output (stabilized power output) for a tandem solar cell comprising amorphous silicon and crystalline silicon. In this figure, the horizontal axis represents the supplied electric power density, and the vertical axis represents a relative value for the module power output (stabilized power output). The robustness of the module power output relative to fluctuations in the electric power density also increased as the hydrogen gas flow rate per unit surface area of the substrate was increased.

As mentioned above, provided the hydrogen gas flow rate per unit surface area of the substrate is at least 80 slm/m², the effect of the hydrogen gas flow rate on the crystallinity of the silicon i-layer can be minimized. Further, in order to reduce the variation in the cell performance caused by the silicon i-layer to a value of not more than approximately 10%, the permissible fluctuation in the supplied electric power density is not more than ±5%. In other words, typical reflected wave fluctuations that occur due to the plasma conditions are permitted. Moreover, even if the supplied electric power density varies between production batches or lots, any reduction in the solar cell power output can be prevented. Accordingly, a high-power output solar cell can be produced with good stability.

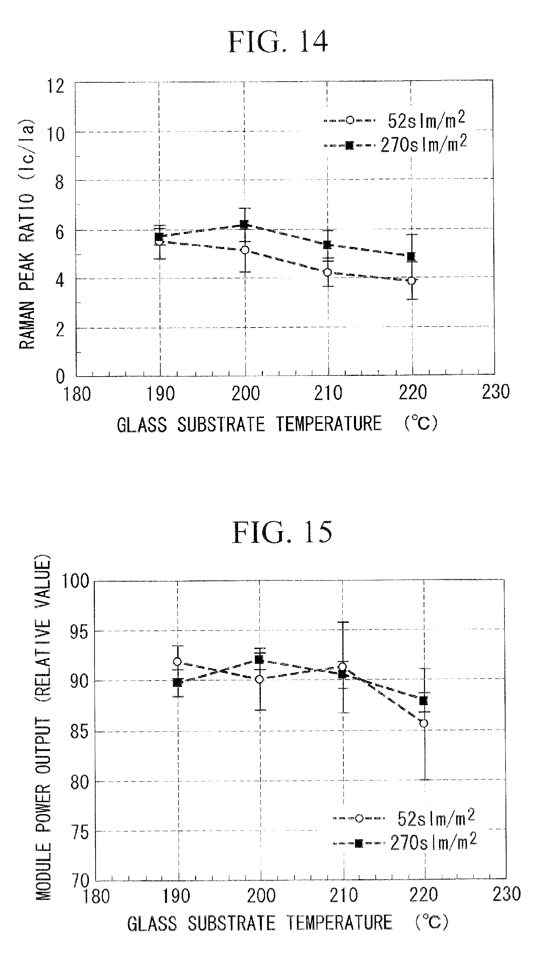

FIG. 14 illustrates the relationship between the glass substrate temperature during deposition and the Raman peak ratio for the crystalline silicon i-layer. In this figure, the horizontal axis represents the substrate temperature, and the vertical axis represents the Raman peak ratio. The size of the glass substrate was 1.4 m × 1.1 m. The deposition rate was not less than 2 nm/s under the standard central conditions. The deposition conditions besides the substrate temperature (such as the total gas flow rate, the substrate-electrode separation distance, and the electric power density) were fixed.
As shown in the results, increasing the hydrogen gas flow rate per unit surface area of the substrate improved the robustness of the film quality relative to fluctuations in the substrate temperature.

FIG. 15 illustrates the relationship between the substrate temperature during deposition of the crystalline silicon i-layer and the module power output (stabilized power output) for a tandem solar cell comprising amorphous silicon and crystalline silicon. In this figure, the horizontal axis represents the substrate temperature, and the vertical axis represents a relative value for the module power output (stabilized power output). The variation in module power output upon fluctuations in the substrate temperature is more gentle than that observed for fluctuations in the total gas flow rate, the electric power density or the substrate-electrode separation distance, but the results still confirmed that increasing the hydrogen gas flow improved the robustness of the module power output relative to fluctuations in the substrate temperature.

If the hydrogen gas flow rate per unit surface area of the substrate is set to a value of at least 80 slm/m² in the manner described above, then in order to suppress the effect of the crystalline silicon i-layer on the cell performance to a variation of not more than approximately 10%, the permissible fluctuation in the substrate temperature is ±15°C. In other words, a typical temperature distribution across a large substrate is permitted, meaning the electric power output of the solar cell can be increased.

Large surface area substrates having a surface area exceeding 1 m² are particularly prone to developing a gas flow rate distribution or a variation in the substrate-electrode separation distance within the substrate plane.
As is evident by reference to FIG. 7, when the hydrogen gas flow rate is set to 52 slm/m², a 10% fluctuation in the total gas flow rate from the set value results in the generation of a region for which the Raman peak ratio is less than 3.5. Furthermore, as can be seen in FIG. 10, if the substrate-electrode separation distance increases even slightly from the standard value, then the Raman peak ratio falls below 3.5. Accordingly, when a crystalline silicon i-layer is deposited on a large surface area substrate under conditions that include a hydrogen gas flow rate of 52 slm/m², regions for which the Raman peak ratio is less than 3.5, and in particular high-brightness reflective regions (for which the Raman peak ratio is 2.5 or less), tend to develop due to distributions in the gas flow rate and the substrate-electrode separation distance, increasing the likelihood of a deterioration in the solar cell module power output.

In contrast, as is clearly evident from FIG. 7 and FIG. 10, if the hydrogen gas flow rate is increased to at least 80 slm/m², which is equivalent to at least 1.5 times the hydrogen gas flow rate selected as the standard flow rate at the conventional hydrogen gas dilution ratio of 45 to 50, then because the resulting robustness relative to those conditions that can cause reductions in the Raman peak ratio (such as an increase in the total gas flow rate or a widening of the substrate-electrode separation distance) is very high, the occurrence of regions in which the Raman peak ratio is less than 3.5, and particularly high-brightness reflective regions, can be suppressed. As a result, the solar cell module power output can be maintained at a high level, enabling high-quality products to be produced in a stable manner, thereby increasing the production yield and raising the productivity.

The description of the above embodiments was presented using the crystalline silicon i-layer as a specific example, but the present invention can also be applied in a similar manner to the deposition of a crystalline silicon p-layer, a crystalline silicon n-layer, or an amorphous silicon layer.

Furthermore, although the above embodiments described a tandem solar cell as the solar cell, the present invention is not restricted to these examples. The present invention can be similarly applied to other types of thin-film solar cells such as amorphous silicon solar cells, crystalline silicon solar cells containing microcrystalline silicon and the like, silicon-germanium solar cells, and triple solar cells.

## Claims

1. A process for producing a photovoltaic device, comprising: forming a silicon-based photovoltaic layer on a substrate using a plasma enhanced CVD method that employs a gas comprising a silane-based gas and hydrogen gas as a raw material gas, under conditions in which a flow rate of the hydrogen gas per unit surface area of the substrate is not less than 80 slm/m².

2. The process for producing a photovoltaic device according to claim 1, wherein a hydrogen dilution ratio, defined as a ratio of a flow rate of the hydrogen gas relative to a flow rate of the silane-based gas, is not less than 40 and not more than 150.

3. The process for producing a photovoltaic device according to claim 1 or claim 2, wherein a surface area of the substrate is at least 1 m².

4. The process for producing a photovoltaic device according to any one of claim 1 to claim 3, wherein the photovoltaic layer is deposited at a rate of not less than 1.5 nm/s.

5. The process for producing a photovoltaic device according to any one of claim 1 to claim 3, wherein the photovoltaic layer is deposited at a rate of not less than 2 nm/s.

6. A photovoltaic device produced using the process according to any one of claim 1 to claim 5, wherein
a surface area of the substrate is at least 1 m²,
the photovoltaic layer comprises a crystalline silicon i-layer,
the crystalline silicon i-layer comprises a region for which a Raman peak ratio, which represents a ratio of a Raman peak intensity for a crystalline silicon phase relative to a Raman peak intensity for an amorphous silicon phase, is within a range from not less than 3.5 to not more than 8, and
a surface area proportion of a region within the substrate plane for which the Raman peak ratio is not more than 2.5 is not more than 3%.
